# EUROPEAN PATENT SPECIFICATION

(11) **EP 3 081 457 B1**
(45) Date of publication and mention of the grant of the patent: **10.04.2019**
(21) Application number: 14869924.2
(22) Date of filing: 12.12.2014
(51) Int. Cl.: B62D 5/04, H02P 29/00, H05K 5/00, H05K 7/20, H05K 7/14, H02P 27/06

(54) **ELECTRONIC CONTROL UNIT, ELECTRIC POWER STEERING DEVICE, AND VEHICLE**
ELEKTRONISCHE STEUEREINHEIT, ELEKTRISCHE SERVOLENKUNG UND FAHRZEUG
UNITÉ DE COMMANDE ÉLECTRONIQUE, DISPOSITIF DE DIRECTION ASSISTÉE ÉLECTRIQUE ET VÉHICULE

(30) Priority: 13.12.2013 JP 2013258298; 13.12.2013 JP 2013258299; 13.12.2013 JP 2013258300; 13.12.2013 JP 2013258301; 20.12.2013 JP 2013263957; 20.12.2013 JP 2013263958; 20.12.2013 JP 2013263959; 20.12.2013 JP 2013263960
(43) Date of publication of application: 19.10.2016
(73) Proprietor: NSK Ltd., Tokyo 141-8560 (JP)
(72) Inventor: INADA, Yoshikatsu, Fujisawa-shi Kanagawa 251-8501 (JP); TAGAMI, Kotaro, Fujisawa-shi Kanagawa 251-8501 (JP); SEKINE, Takaaki, Tokyo 141-8560 (JP)
(74) Representative: Klingseisen, Franz
(86) International application number: PCT/JP2014/006199
(87) International publication number: WO 2015/087553

(56) References cited:
- EP-A1- 1 615 317
- JP-A- 2002 246 537
- JP-A- 2003 309 384
- JP-A- 2010 105 639
- JP-A- 2012 074 440
- US-B2- 7 909 130

## Description

### Technical Field

The present invention relates to an electronic controlling unit, an electric power steering device, and a vehicle and, more particularly, to an electronic controlling unit which controls driving of an electric motor, an electric power steering device which uses the electronic controlling unit, and a vehicle equipped with the electric power steering device.

### Background Art

An electronic controlling unit in an electric power steering device controls driving of an electric motor, and includes a power module and a control board. The power module includes a switching element. The control board includes a controller which controls the output current of the power module.

The electronic controlling unit and the electric motor require reduction in size to flexibly adapt to a vehicle mounting position corresponding to the type of vehicle. To meet this requirement, PTL1 proposes an electric power steering device which employs an electronic controlling unit and an electric motor integrated with each other.

The electronic controlling unit in the electric power steering device according to PTL 1 includes a power module, a controlling module, a DC conduction module, and an AC conduction module. The power module includes a switching element. The controlling module controls the output current of the power module. The DC conduction module includes a power terminal block supplied with power from a battery. The AC conduction module includes a motor terminal block which supplies power to the electric motor. These components are accommodated in a rectangular housing.

A controller for electric power steering drive system is disclosed in EP 1 615 317 A1 including a motor controller with a power module and a conductor module wherein the terminal of the power module and the bus bar of the conductor module are connected by welding and the terminal of the power module and the terminal of the control module are connected by soldering. These components of this known electronic control unit are accommodated in a rectangular conventional housing.

### Citation List

Patent Literature
PTL 1: JP 2010-30489 A

### Summary of Invention

### Technical Problem

With the recent sophistication of vehicles such as automobiles, not only an engine but also a variety of electronic components and devices are packed in an engine compartment. Under the circumstances, an electronic controlling unit which controls driving of an electric motor in an electric power steering device requires further reduction in size.

Since the power module including a switching element generates heat in large quantities, an improvement in its heat radiation performance is also required with the downsizing of the electronic controlling unit.

The inventor of the present invention made this invention by focusing attention on the fact that the conventional electronic controlling unit has a rectangular housing.

It is an object of the present invention to provide an electronic controlling unit which can have a relatively small size, an electric power steering device which uses the electronic controlling unit, and a vehicle equipped with the electric power steering device.

### Solution to Problem

This problem is solved by means of an electronic controlling unit with the features of claim 1. Preferred forms of realization are defined in dependent claims.

(1) In order to achieve the object, there is provided with an electronic controlling unit comprising: a power module including a switching element; an input/output board including an input connector and an output connector; a control board including a controller configured to control an output current of the power module; and a housing configured to accommodate the power module, the input/output board, and the control board. The housing includes a mounting portion and a ceiling portion opposed to each other with a spacing therebetween in one direction, and at least four side wall portions located between the mounting portion and the ceiling portion. At least one of the at least four side wall portions is an inclined side wall portion inclined inwardly at an acute angle with respect to the mounting portion.
(2) In the electronic controlling unit according to above-described (1), the input/output board and the control board are opposed to each other with a predetermined spacing therebetween in the one direction. The power module includes a sealing member having a square planar shape, a plurality of first leads aligned along one side of two opposite sides of the sealing member, and a plurality of second leads aligned along the other side of the two sides of the sealing member. The first leads are connected to the input/output board. The second leads are connected to the control board. The sealing member is tilted along the inclined side wall portion.
(3) In the electronic controlling unit according to above-described (1) or (2), the sealing member is connected to the inclined side wall portion directly or indirectly via a heat conducting member.
(4) In the electronic controlling unit according to any one of above-described (1) to (3), the electronic controlling unit is used to control driving of an electric motor.
(5) An electric power steering device includes the electronic controlling unit according to above-described (4), the electric motor generates a steering assist force to assist steering operation.
(6) The present invention provides a vehicle equipped with the electric power steering device according to above-described (5).
(7) An electronic controlling unit according to an aspect of the present invention includes power modules, an input/output board, a control board, a housing, and a positioning mechanism. The power modules include switching elements. The input/output board includes an input connector and an output connector. The control board includes a controller which controls the output current of each of the power modules. The housing accommodates the power modules, the input/output board, and the control board. The positioning mechanism positions the power modules in the housing.
(8) In the electronic controlling unit according to above-described (7), preferably, the housing includes side wall portions, and the positioning mechanism includes positioning projections and positioning terminals. The positioning projections are formed inside the side wall portions of the housing. The positioning terminals are provided in the power modules and include fitting holes to be engaged by the positioning projections.
(9) In the electronic controlling unit according to above-described (7) or (8), preferably, the input/output board and the control board have flat surfaces facing each other with a predetermined spacing between them, and each of the power modules includes a sealing member, a plurality of first leads, a plurality of second leads, and the positioning terminals. The sealing member has a square planar shape. The plurality of first leads are aligned along one side of two opposite sides of the sealing member. The plurality of second leads are aligned along the other side of the two sides of the sealing member. The plurality of first leads are connected to the input/output board. The plurality of second leads are connected to the control board. The positioning terminals are electrically insulated from the first and second leads.
(10) In the electronic controlling unit according to any one of above-described (7) to (9), the positioning mechanism is preferably configured to position the first leads and the connecting portion of the input/output board relative to each other and position the second leads and the connecting portion of the control board relative to each other.
(11) An electric power steering device according to an aspect of the present invention includes the electronic controlling unit according to any one of above-described (7) to (10).
(12) A vehicle according to an aspect of the present invention includes the power steering device according to above-described (11).
(13) An electronic controlling unit according to an aspect of the present invention includes first and second power modules, an input/output board, a control board, and a housing. Each of the first and second power modules includes a switching element. The input/output board includes an input connector and an output connector. The control board includes a controller which controls the output current of each of the first and second power modules. The housing accommodates the power modules, the input/output board, and the control board. The input/output board and the control board have flat surfaces facing each other with a predetermined spacing between them. Each of the first and second power modules includes a switching element as well as a sealing member, a plurality of first leads, and a plurality of second leads . The sealing member has a square planar shape . The plurality of first leads are aligned along one side of two opposite sides of the sealing member. The plurality of second leads are aligned along the other side of the two sides of the sealing member. The first leads are connected to the input/output board. The second leads are connected to the control board. The respective sealing members of the first and second power modules are spaced apart from each other and from the input/output board and the control board.
(14) In the electronic controlling unit according to above-described (13), preferably, each of the input/output board and the control board includes first and second sides opposed to each other with a spacing between them in the one direction, the first power module is located closer to the first side of each of the input/output board and the control board, and the second power module is located closer to the second side of each of the input/output board and the control board.
(15) In the electronic controlling unit according to above-described (13) or (14), preferably, the housing includes first and second side wall portions opposed to each other in the one direction, the sealing member of the first power module is connected to the first side wall portion of the housing directly or via a heat conducting member, and the sealing member of the second power module is connected to the second side wall portion of the housing directly or via a heat conducting member.
(16) In the electronic controlling unit according to any one of above-described (13) to (15), preferably, the plurality of first leads of the first power module and the plurality of first leads of the second power module include leads arranged in mirror symmetry, in which leads having the same function are opposed to each other in the one direction.
(17) The electronic controlling unit according to any one of above-described (13) to (16) preferably serves as an electronic controlling unit for an electric motor which controls driving of the electric motor.
(18) An electric power steering device according to an aspect of the present invention includes the electronic controlling unit according to above-described (17).
(19) A vehicle according to an aspect of the present invention includes the electric power steering device according to above-described (18).

### Advantageous Effects of Invention

The present invention can provide an electronic controlling unit which can have a relatively small size, an electric power steering device which uses the electronic controlling unit, and a vehicle equipped with the electric power steering device.

### Brief Description of Drawings

FIG. 1 is a view illustrating the basic structure of an electric power steering device mounted in a vehicle according to the present invention;
FIG. 2 is a block diagram illustrating the controlling system of a motor controlling device in the electric power steering device illustrated in FIG. 1;
FIG. 3 is an exploded perspective view illustrating the internal arrangement of an electronic controlling unit serving as the motor controlling device according to the present invention;
FIG. 4 is a perspective view illustrating the outer arrangement of the electronic controlling unit according to the present invention;
FIG. 5 is a first side view when viewed from a direction indicated by an arrow L1 in FIG. 4;
FIG. 6 is a second side view when viewed from a direction indicated by an arrow L2 in FIG. 4;
FIG. 7 is a perspective view illustrating the power module taken from FIG. 3;
FIG. 8 is a view when viewed from a direction indicated by an arrow L3 in FIG. 7; and
FIG. 9 is a sectional view illustrating the schematic arrangement of a housing in the electronic controlling unit according to the present invention.

### Description of Embodiments

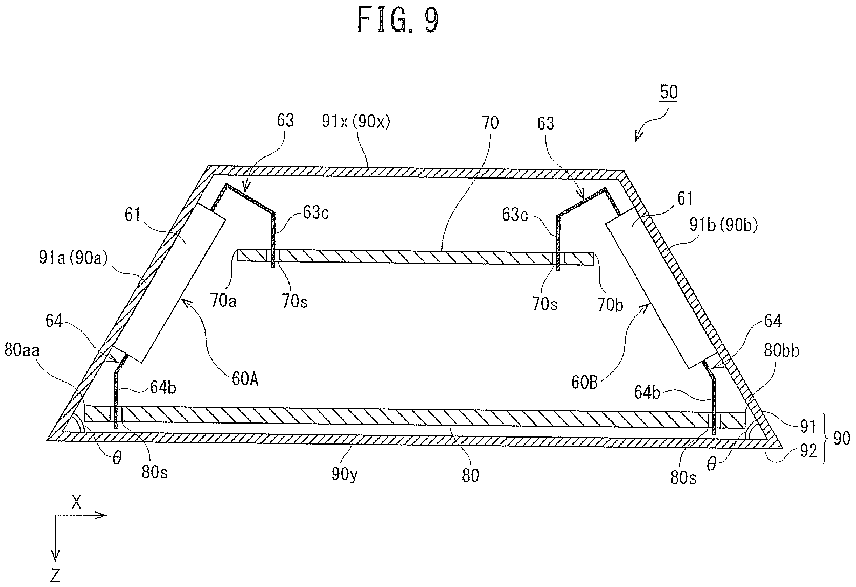

A mode (to be referred to as an embodiment hereinafter) for carrying out the present invention will now be described with reference to the drawings. For the sake of easier viewing, FIG. 9 does not illustrate electronic components mounted on an input/output board 70 and a control board 80 (both will be described later).

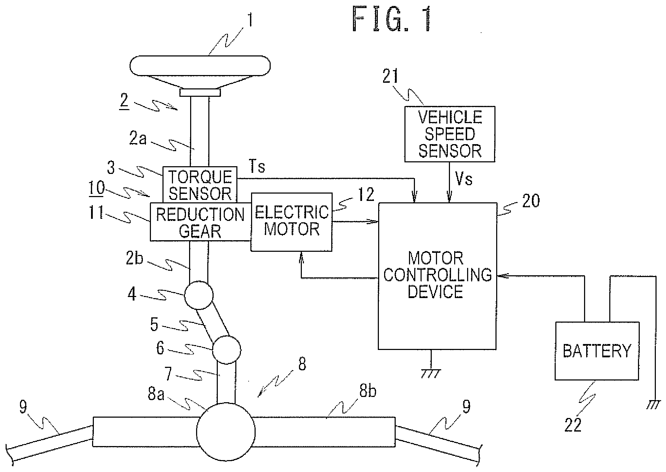

FIG. 1 is a view illustrating an electric power steering device mounted in a vehicle according an embodiment of the present invention.

Referring to FIG. 1, reference numeral 1 denotes a steering wheel. A steering force generated as the driver operates the steering wheel 1 is transmitted to a steering shaft 2. The steering shaft 2 includes an input shaft 2a and an output shaft 2b. The input shaft 2a has its one end connected to the steering wheel 1 and its other end connected to one end of the output shaft 2b via a steering torque sensor 3.

The steering force transmitted to the output shaft 2b is further transmitted to a lower shaft 5 via a universal joint 4 and to a pinion shaft 7 via a universal joint 6. The steering force transmitted to the pinion shaft 7 is further transmitted to tie rods 9 via a steering gear 8 to turn a steered wheel (not illustrated). The steering gear 8 employs a rack-and-pinion system including a pinion 8a connected to the pinion shaft 7 and a rack 8b which meshes with the pinion 8a. The steering gear 8 converts a rotational motion transmitted to the pinion 8a into a rectilinear motion in the vehicle widthwise direction in the rack 8b.

A steering assist mechanism 10 which transmits a steering assist force to the output shaft 2b of the steering shaft 2 is connected to the output shaft 2b of the steering shaft 2. The steering assist mechanism 10 includes a reduction gear 11 and an electric motor 12. The reduction gear 11 includes, for example, a worm gear mechanism connected to the output shaft 2b. The electric motor 12 is implemented in, for example, a three-phase brushless motor which is connected to the reduction gear 11 and produces a steering assist force.

The steering torque sensor 3 detects a steering torque applied to the steering wheel 1 and transmitted to the input shaft 2a. The steering torque sensor 3, for example, converts the steering torque into a rotational angular displacement of a torsion bar (not illustrated) interposed between the input shaft 2a and the output shaft 2b. The steering torque sensor 3 converts the rotational angular displacement into an angular difference between an input-side angle sensor (not illustrated) placed close to the input shaft 2a and an output-side angle sensor (not illustrated) placed close to the output shaft 2b, and detects the angular difference.

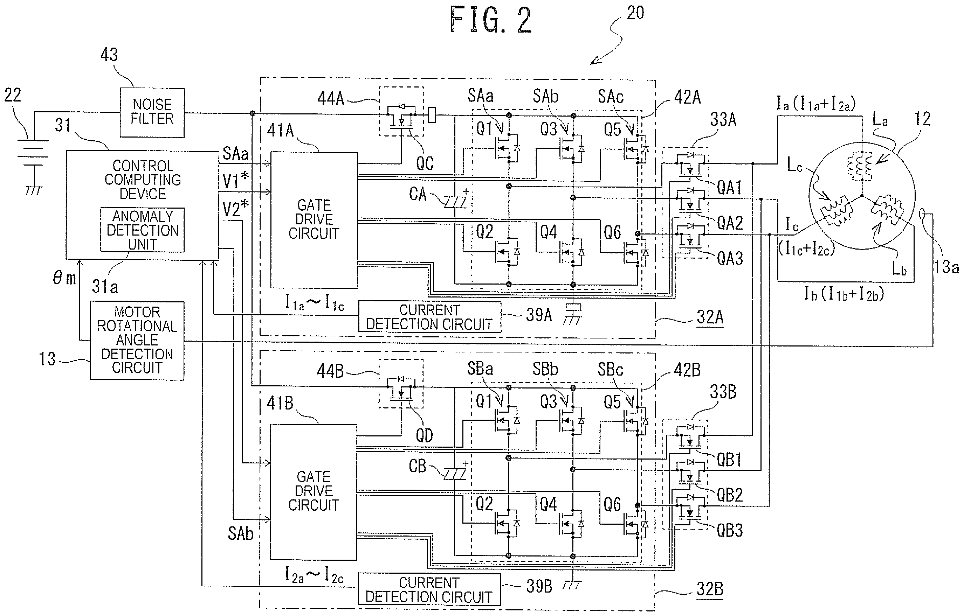

The electric motor 12 is implemented in a three-phase brushless motor and includes motor windings La, Lb, and Lc of three phases: phases A, B, and C which are wound around the slots of a stator, as illustrated in FIG. 2. The motor windings La, Lb, and Lc of the respective phases have their one-side ends connected to each other in a star connection configuration and their other-side ends connected to a motor controlling device 20 and supplied with motor drive currents Ia, Ib, and Ic, respectively.

The electric motor 12 includes a rotational position sensor 13a which detects the motor rotational position, as illustrated in FIG. 2. The value detected by the rotational position sensor 13a is supplied to a motor rotational angle detection circuit 13, which detects a motor rotational angle θm.

The motor controlling device 20 receives a DC current from a battery 22 serving as a DC power supply.

The motor controlling device 20 includes a control computing device 31, first and second motor drive circuits 32A and 32B, and motor current cutoff circuits 33A and 33B, as illustrated in FIG. 2. The control computing device 31 computes three-phase voltage command values V1* and V2*. The first and second motor drive circuits 32A and 32B receive the three-phase voltage command values V1* and V2* output from the control computing device 31. The motor current cutoff circuits 33A and 33B are interposed between the first and second motor drive circuits 32A and 32B and the multiphase motor windings La, Lb, and Lc of the electric motor 12.

The control computing device 31 receives a steering torque detected by the steering torque sensor 3, a vehicle speed detected by a vehicle speed sensor 21, a motor rotational angle θm output from the motor rotational angle detection circuit 13, a motor angular velocity, and a motor angular acceleration. The control computing device 31 further receives motor drive currents I1a to I1c and I2a to I2c output from current detection circuits 39A and 39B and supplied to the motor windings La, Lb, and Lc of the respective phases of the electric motor 12. The control computing device 31 calculates three-phase voltage command values V1* and V2* for the first and second motor drive circuits 32A and 32B based on the steering torque, the vehicle speed, the motor rotational angle θm, the motor angular velocity, and the motor angular acceleration. The control computing device 31 outputs the calculated three-phase voltage command values V1* and V2* to gate drive circuits 41A and 41B (to be described later) of the first and second motor drive circuits 32A and 32B.

The control computing device 31 includes an anomaly detection unit 31a. The anomaly detection unit 31a detects open-circuit failure of the upper arm of field-effect transistors (FETs) Q1 to Q6 serving as switching elements which are included in first and second inverter circuits 42A and 42B (to be described later), short-circuit failure of the lower arm of the field-effect transistors (FETs) Q1 to Q6, and a burnout anomaly in the coil portions of the motor windings La, Lb, and Lc of the respective phases of the electric motor 12. In the anomaly detection unit 31a, when open-circuit failure and short-circuit failure of the field-effect transistors (FETs) Q1 to Q6 are not detected, anomaly detection signals SAa and SAb having logical value "0" (normal) are output to the gate drive circuits 41A and 41B of the motor drive circuits 32A and 32B. When open-circuit failure and short-circuit failure of the field-effect transistors (FETs) Q1 to Q6 are detected, an anomaly detection signal SAa or SAb having logical value "1" (anomalous) is output to the gate drive circuit 41A or 41B of the motor drive circuit 32A or 32B whose anomaly has been detected.

The first and second motor drive circuits 32A and 32B include gate drive circuits 41A and 41B, respectively, and first and second inverter circuits 42A and 42B, respectively. The gate drive circuits 41A and 41B form gate signals upon receiving the three-phase voltage command values V1* and V2* output from the control computing device 31, and serve as anomaly time current controlling units. The first and second inverter circuits 42A and 42B receive the gate signals output from the gate drive circuits 41A and 41B.

When the anomaly detection signal SAa received from the control computing device 31 has logical value "0" (normal), the gate drive circuit 41A outputs three high-level gate signals to the motor current cutoff circuit 33A and a high-level gate signal to a power cutoff circuit 44A. When the anomaly detection signal SAa has logical value "1" (anomalous), the gate drive circuit 41A simultaneously outputs three low-level gate signals to the motor current cutoff circuit 33A to cut off the motor drive currents I1a to I1c and outputs a low-level gate signal to the power cutoff circuit 44A to cut off the battery power.

Similarly, when the anomaly detection signal SAa received from the control computing device 31 has logical value "0" (normal), the gate drive circuit 41B outputs three high-level gate signals to the motor current cutoff circuit 33B and a high-level gate signal to a power cutoff circuit 44B. When the anomaly detection signal SAa has logical value "1" (anomalous), the gate drive circuit 41B simultaneously outputs three low-level gate signals to the motor current cutoff circuit 33B to cut off the motor drive currents I2a to I2c and outputs a low-level gate signal to the power cutoff circuit 44B to cut off the battery current.

The first and second inverter circuits 42A and 42B receive the battery power of the battery 22 via a noise filter 43 and the power cutoff circuits 44A and 44B, respectively, and are connected to smoothing electrolytic capacitors CA and CB, respectively, on the input sides.

Each of the first and second inverter circuits 42A and 42B includes six field-effect transistors (FETs) Q1 to Q6 serving as switching elements, and a parallel circuit of three switching arms SAa, SAb, and SAc each including a series circuit of two field-effect transistors. The field-effect transistors Q1 to Q6 that are included in the first inverter circuit 42A receive the gate signal output from the gate drive circuit 41A to supply a phase-A motor drive current I1a, a phase-B motor drive current I1b, and a phase-C motor drive current I1c from the intervals between the field-effect transistors of the respective switching arms SAa, SAb, and SAc to the motor windings La, Lb, and Lc of the respective phases of the electric motor 12 via the motor current cutoff circuit 33A. The field-effect transistors Q1 to Q6 that are included in the second inverter circuit 42B receive the gate signal output from the gate drive circuit 41B to supply a phase-A motor drive current I2a, a phase-B motor drive current I2b, and a phase-C motor drive current I2c from the intervals between the field-effect transistors of the respective switching arms SBa, SBb, and SBc to the motor windings La, Lb, and Lc of the respective phases of the electric motor 12 via the motor current cutoff circuit 33B.

The motor current cutoff circuit 33A includes three field-effect transistors QA1 to QA3 for current cutoff. The motor current cutoff circuit 33B includes three field-effect transistors QB1 to QB3 for current cutoff.

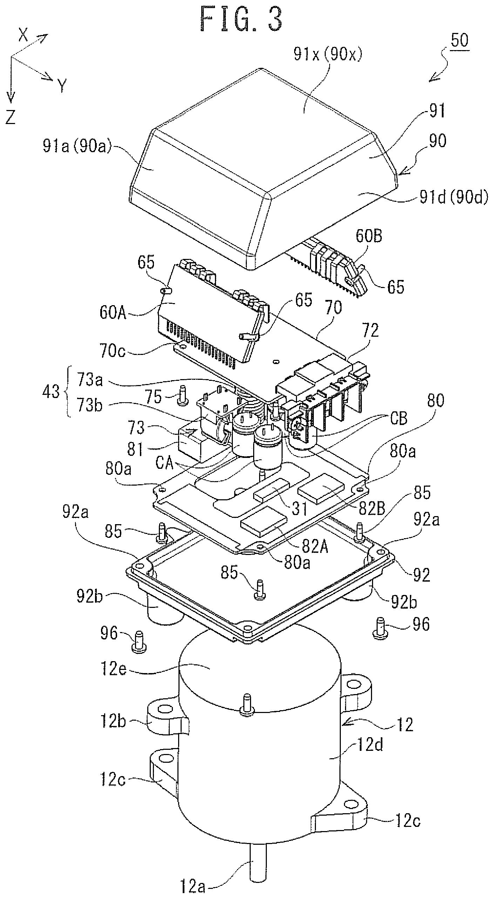

The configuration of an electronic controlling unit 50 serving as the motor controlling device 20 will be described below with reference to FIGS. 3 to 9.

In an embodiment of the present invention, first and second directions orthogonal to each other in the same plane will sometimes be referred to as the X- and Y-directions hereinafter. A third direction perpendicular to the X- and Y-directions will sometimes be referred to as the Z-direction hereinafter.

The electronic controlling unit 50 mainly includes first and second power modules 60A and 60B, an input/output board 70, a control board 80, and a housing 90 which accommodates these components, as illustrated in FIG. 3.

The first power module 60A mainly includes, for example, the motor current cutoff circuit 33A, the first inverter circuit 42A including a plurality of switching elements, and the power cutoff circuit 44A that are illustrated in FIG. 2. The second power module 60B mainly includes, for example, the motor current cutoff circuit 33B, the second inverter circuit 42B including a plurality of switching elements, and the power cutoff circuit 44B that are illustrated in FIG. 2. In other words, the electronic controlling unit 50 according to an embodiment includes duplex first and second power modules 60A and 60B, so that even when either power module suffers failure, the remaining power module can control driving of the electric motor 12.

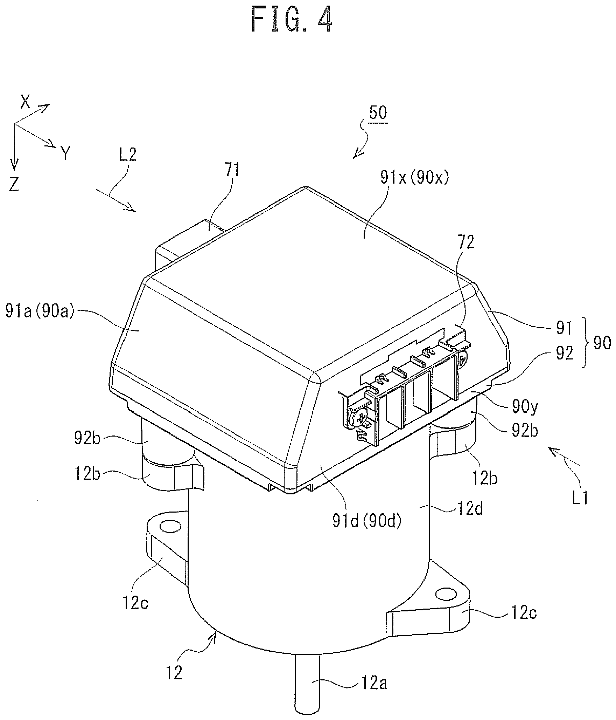

The input/output board 70 includes a power input connector 71 (see FIG. 4) and a three-phase output connector 72, as well as electrolytic capacitors (CA and CB), coils 73a and 73b which form the noise filter 43, resistors, and electronic components (discrete components) 73 such as a three-terminal regulator, as illustrated in FIG. 3.

The power input connector 71 and the three-phase output connector 72 correspond to an input connector and an output connector, respectively, of the present invention.

The control board 80 includes, for example, a control computing device 31 and gate drive devices 82A and 82B, as well as capacitors, resistors, and electronic components such as a signal input connector 81, as illustrated in FIG. 3. The control computing device 31 serves as a controller which controls the output currents of the first and second power modules 60A and 60B. The gate drive device 82A includes the gate drive circuit 41A illustrated in FIG. 2. The gate drive device 82B includes the gate drive circuit 418 illustrated in FIG. 2. The control board 80 and the input/output board 70 have a multilayer wiring structure including wiring layers in, for example, the front and back surfaces or the front and back surfaces and inner layers. Examples of the control board 80 and the input/output board 70 include a printed circuit board, a ceramic circuit board, and an insert-molded circuit board including an insert base.

The housing 90 mainly includes a case 91 and a cover 92, which form an accommodation unit accommodating, for example, the first and second power modules 60A and 60B, the input/output board 70, and the control board 80, as illustrated in FIG. 3. The case 91 and the cover 92 are made of a conductive metal material such as aluminum die-cast (ADC).

The case 91 and the cover 92 have a square planar shape when viewed in a plan view, as illustrated in FIGS. 3 to 6 and 9. The case 91 has a recessed configuration including a ceiling portion 91x, four side wall portions 91a, 91b, 91c, and 91d integrated with the edges of the ceiling portion 91x to surround the center of the ceiling portion 91x, and an opening portion opposed to the ceiling portion 91x. The cover 92 is mounted to cover the opening portion. Of the four side wall portions 91a, 91b, 91c, and 91d, the two side wall portions 91a and 91b are opposed to each other with a spacing between them in the X-direction while the remaining two side wall portions 91c and 91d are opposed to each other with a spacing between them in the Y-direction perpendicular to the X-direction.

The cover 92 has a planar shape. Boss portions 92b are formed on the lower surface of the cover 92 to be screwed to the electric motor 12 (to be described later) by screw members.

The ceiling portion 91x of the case 91 forms the ceiling portion 90x of the housing 90 while the four side wall portions 91a, 91b, 91c, and 91d of the case 91 form four side wall portions 90a, 90b, 90c, and 90d, respectively, of the housing 90. The cover 92 forms a mounting portion 90y of the housing 90. In other words, the housing 90 includes a ceiling portion 90x and a mounting portion 90y opposed to each other with a spacing between them in the direction of thickness (Z-direction) of the housing 90, and four side wall portions 90a, 90b, 90c, and 90d located between the ceiling portion 90x and the mounting portion 90y. The accommodation unit surrounded by the ceiling portion 90x, the mounting portion 90y, and the four side wall portions 90a, 90b, 90c, and 90d accommodates, for example, the first and second power modules 60A and 60B, the input/output board 70, and the control board 80.

The first and second power modules 60A and 60B are individually screwed to the two opposed side wall portions 91a and 91b, respectively, of the case 91 by screw members 65 from inside, as illustrated in FIG. 3.

The input/output board 70 is screwed to the ceiling portion 91x of the case 91 by screw members 75 from inside.

The control board 80 is screwed to the ceiling portion 91x of the case 91 by screw members 85 from inside. The cover 92 is screwed to the side wall portions 91a, 91b, 91c, and 91d of the case 91 by screw members 96 from inside. The input/output board 70 and the control board 80 are opposed to each other with a predetermined spacing between them in the direction of thickness (Z-direction) of the electronic controlling unit 50.

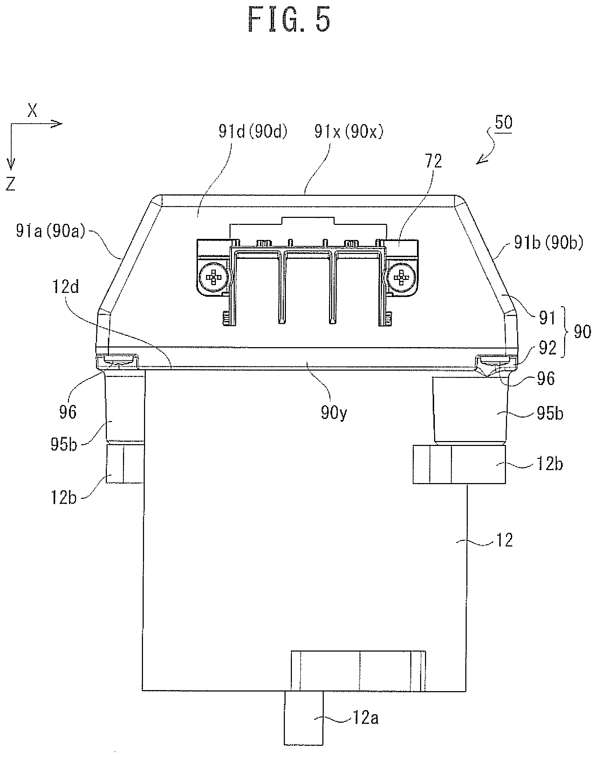

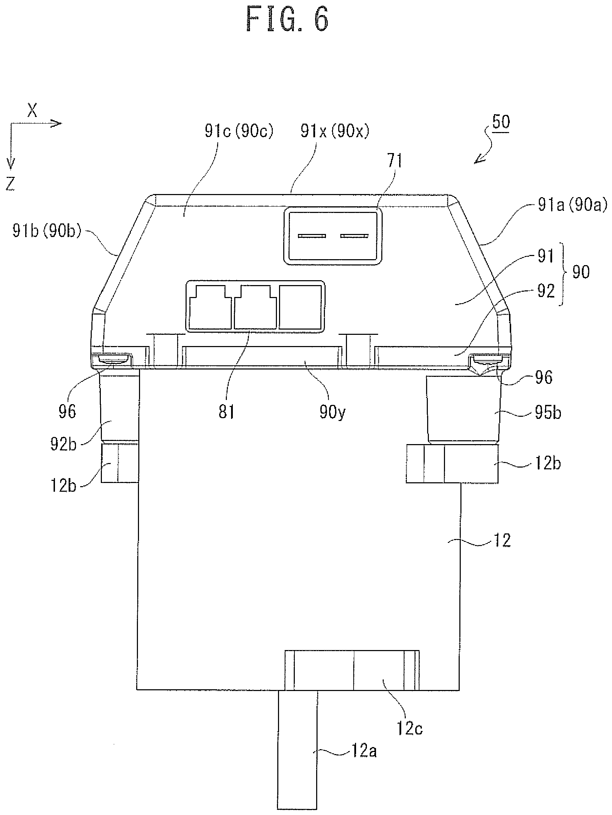

The three-phase output connector 72 of the input/output board 70 is exposed outside from the side wall portion 91d of the case 91, as illustrated in FIGS. 4 and 5. The power input connector 71 of the input/output board 70 and the signal input connector 81 of the control board 80 are exposed outside from the side wall portion 91c of the case 91, as illustrated in FIG. 6.

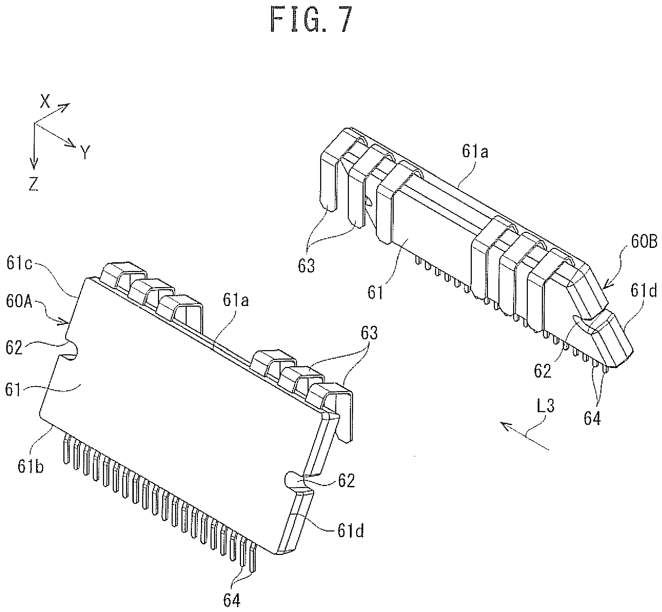

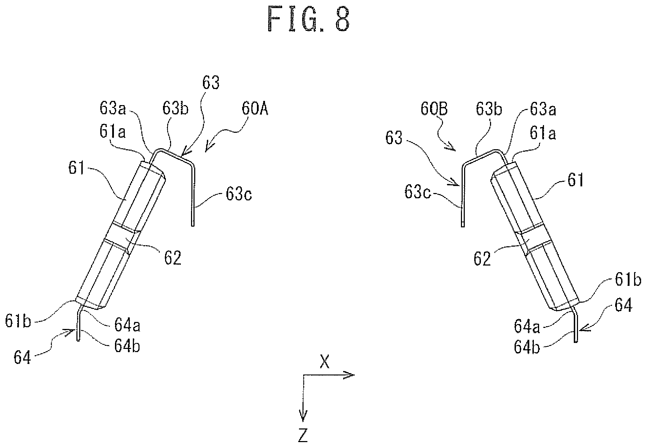

Each of the first and second power modules 60A and 60B includes a sealing member 61, a plurality of first leads 63, and a plurality of second leads 64, as illustrated in FIGS. 7 and 8. Each of the first and second power modules 60A and 60B has a bidirectional lead array package structure.

The sealing member 61 has a square planar shape when viewed in a plan view and is formed in, for example, a rectangle having two long sides 61a and 61b and two short sides 61c and 61d in an embodiment of the present invention. The sealing member 61 is made of, for example, an insulating resin or ceramics. The sealing member 61 of the first power module 60A mainly seals, for example, the switching elements that are included in the first inverter circuit 42A illustrated in FIG. 2. The sealing member 61 of the second power module 60B mainly seals, for example, the switching elements that are included in the second inverter circuit 42B illustrated in FIG. 2.

Although not illustrated in detail, each of the pluralities of first and second leads 63 and 64 extends into and out of the sealing member 61, and includes an internal lead portion located inside the sealing member 61 and an external lead portion located outside the sealing member 61.

The plurality of first leads 63 are aligned along one long side 61a of the two long sides 61a and 61b of the sealing member 61 in their external lead portions located outside the sealing member 61. The plurality of second leads 64 are aligned along the other long side 61b of the two long sides 61a and 61b of the sealing member 61 in their external lead portions located outside the sealing member 61.

Each of the pluralities of first and second leads 63 and 64 is bent in a plurality of steps in their external lead portions located outside the sealing member 61, as illustrated in FIG. 8.

The external lead portion of each of the plurality of first leads 63 is bent in, for example, three steps and includes a first portion 63a, a second portion 63b, and a third portion 63c. The first portion 63a projects from one long side 61a of the sealing member 61. The second portion 63b is bent in the direction of thickness of the sealing member 61 from the first portion 63a. The third portion 63c is bent from the second portion 63b toward the back surface of the sealing member 61.

The external lead portion of each of the plurality of second leads 64 is bent in, for example, two steps and includes a first portion 64a and a second portion 64b, as illustrated in FIG. 8. The first portion 64a projects from the other long side 61b of the sealing member 61. The second portion 64b is bent and tilted from the first portion 64a to the back surface of the sealing member 61.

The sealing member 61 includes notched portions 62 on the two opposite short sides 61c and 61d, respectively, as illustrated in FIGS. 7 and 8. The notched portions 62 are used to pass the screw members 65 (see FIG. 3) when the first and second power modules 60A and 60B are screwed to the inner wall of the case 91.

In the first and second power modules 60A and 60B, each of the plurality of first leads 63 is electrically, mechanically connected by, for example, soldering to a through-hole electrode 70s (see FIG. 9) forming part of the wiring of the input/output board 70. Each of the plurality of second leads 64 is electrically, mechanically connected by, for example, soldering to a through-hole electrode 80s (see FIG. 9) forming part of the wiring of the control board 80.

The plurality of first leads 63 include a first lead 63 electrically connected to the terminal of the power input connector 71, and a first lead 63 electrically connected to the terminal of the three-phase output connector 72, via the wiring of the input/output board 70. The plurality of second leads 64 include a second lead 64 electrically connected to the terminal of the signal input connector 81 via the wiring of the control board 80.

The electric motor 12 includes a motor stator (not illustrated), a motor rotor (not illustrated), a cylindrical motor frame 12d, a motor output shaft 12a, first mounting flanges 12b, and second mounting flanges 12c, as illustrated in FIG. 3. The motor stator is formed by winding three-phase coils. The motor frame 12d includes the rotational position sensor 13a illustrated in FIG. 2. The motor output shaft 12a is connected to the motor stator and projects out of the motor frame 12d. The first mounting flanges 12b are placed in the vicinities of a top plate 12e of the motor frame 12d placed in correspondence with the motor output shaft 12a at the opposite position. The second mounting flanges 12c are formed on the open end portions of the motor frame 12d from which the motor output shaft 12a projects and are attached to side of a gear box (not illustrated) including the reduction gear 11.

The electronic controlling unit 50 is placed such that the cover 92 (mounting portion 90y) abuts against the top plate 12e of the electric motor 12. Boss portions 95b formed on the cover 92 are fitted and screwed into the first mounting flanges 12b by screw members (not illustrated) to attach the electronic controlling unit 50 to the electric motor 12, as illustrated in FIGS. 3 to 6.

The procedure of assembly of an electronic controlling unit 50 will be described below with reference to FIGS. 3 to 9.

First and second power modules 60A and 60B, an input/output board 70, a control board 80, a case 91, and a cover 92 are provided first. The input/output board 70 includes a power input connector 71, a three-phase output connector 72, electrolytic capacitors CA and CB, coils 73e and 73b which form a noise filter 43, resistors, and electronic components (discrete components) 73 such as a three-terminal regulator. The control board 80 includes electronic components such as gate drive devices (gate drive circuits 41A and 41B) and a controller (control computing device 31) which controls the output currents of the first and second power modules 60A and 60B, as well as electronic components such as capacitors, resistors, and a signal input connector 81.

The first and second power modules 60A and 60B are individually screwed to side wall portions 91a and 91b, respectively, of the case 91 by screw members 65 from inside. The input/output board 70 is screwed at a position adjacent to the inner wall of the ceiling portion 91x of the case 91 by screw members 75. The input/output board 70 includes a plurality of screw holes 70c. In screwing, the screw members 75 are inserted into the screw holes 70c, as illustrated in FIG. 3. In screwing the input/output board 70 to the ceiling portion 91x of the case 91, the distal end portions (third portions 63c) of the plurality of first leads 63 of each of the first and second power modules 60A and 60B are inserted into through-hole electrodes 70s formed on the wiring of the input/output board 70, as illustrated in FIG. 9.

The control board 80 is screwed by screw members 85 at a position spaced apart from the inner wall of the ceiling portion 91x of the case 91 in parallel with the input/output board 70. The control board 80 includes a plurality of screw holes 80a. In screwing, the screw members 85 are inserted into the screw holes 80a. In screwing the control board 80 to the ceiling portion 91x of the case 91, the distal end portions (second portions 64b) of the plurality of second leads 64 of each of the first and second power modules 60A and 60B are inserted into through-hole electrodes 80s formed on the wiring of the control board 80, as illustrated in FIG. 9.

The distal end portions (third portions 63c) of the plurality of first leads 63 of each of the first and second power modules 60A and 60B are electrically, mechanically connected by soldering to the through-hole electrodes 70s formed on the wiring of the input/output board 70. At the same time, the distal end portions (second portions 64b) of the plurality of second leads 64 of each of the first and second power modules 60A and 60B are electrically, mechanically connected by soldering to the through-hole electrodes 80s formed on the wiring of the control board 80.

The cover 92 is mounted to cover the opening in the case 91 and screwed to the side wall portions 91a, 91b, 91c, and 91d of the case 91 by screw members 96 from the outside of the cover 92. The cover 92 includes a plurality of screw holes 92a. In screwing, the screw members 96 are inserted into the screw holes 92a. With this operation, assembly of an electronic controlling unit 50 according to an embodiment of the present invention is nearly completed.

In the electronic controlling unit 50, the input/output board 70 and the control board 80 are opposed to each other with a predetermined spacing between them in the direction of thickness (Z-direction) of the electronic controlling unit 50, as illustrated in FIG. 9. In an embodiment of the present invention, the input/output board 70 is located closer to the ceiling portion 91x of the case 91 than the control board 80, and the control board 80 is located closer to the cover 92 than the input/output board 70.

The input/output board 70 has a planar size smaller than that of the control board 80. The input/output board 70 includes two opposite sides 70a and 70b and the control board 80 includes two opposite sides 80aa and 80bb.

One side 70a of the input/output board 70 is located on the same side as one side 80aa of the control board 80 and inside this side 80aa. The other side 70b of the input/output board 70 is located on the same side as the other side 80bb of the control board 80 and inside this side 80bb.

The first power module 60A is placed on the side of one side 70a and one side 80aa of the input/output board 70 and the control board 80, respectively, to traverse one side 70a of the input/output board 70. The second power module 60B is placed on the side of the other side 70b and the other side 80bb of the input/output board 70 and the control board 80, respectively, to traverse the other side 70b of the input/output board 70.

The configuration of the electronic controlling unit 50 according to an embodiment of the present invention will be described in more detail.

The housing 90 includes four side wall portions 90a, 90b, 90c, and 90d, as described earlier. Of the four side wall portions 90a, 90b, 90c, and 90d, the two side wall portions 90a and 90b opposed to each other in the X-direction are inclined inwardly at an acute angle θ with respect to the mounting portion 90y, as illustrated in FIG. 9. The two side wall portions 90a and 90b inclined inwardly at an acute angle θ with respect to the mounting portion 90y correspond to inclined side wall portions according to the present invention.

In the first power module 60A, the sealing member 61 extends along the side wall portion (inclined side wall portion) 90a, as illustrated in FIG. 9. In the second power module 60B, the sealing member 61 extends along the side wall portion (inclined side wall portion) 90b.

In each of the first and second power modules 60A and 60B, the third portion 63c of each of the plurality of first leads 63 bent in three steps is inserted into the through-hole electrode 70s placed on the input/output board 70 and is electrically, mechanically connected to it by soldering, as illustrated in FIG. 9.

In each of the first and second power modules 60A and 60B, the second portion 64b of each of the plurality of second leads 64 bent in two steps is inserted into the through-hole electrode 80s placed on the control board 80 and is electrically, mechanically connected to it by soldering.

In the first lead 63 of each of the first and second power modules 60A and 60B, the third portion 63c is bent nearly perpendicularly to the electronic component mounting surface of the input/output board 70 to tilt the first and second power modules 60A and 60B, as illustrated in FIG. 9.

In the second lead 64 of each of the first and second power modules 60A and 60B, the second portion 64b is bent nearly perpendicularly to the electronic component mounting surface of the control board 80 to tilt the first and second power modules 60A.

In the first power module 60A, the sealing member 61 is connected to the side wall portion (inclined side wall portion) 90a of the housing 90 directly or via a heat conducting member. In the second power module 60B, the sealing member 61 is connected to the side wall portion (inclined side wall portion) 90b of the housing 90 directly or via a heat conducting member. Examples of the heat conducting member include sheet-shaped heat conducting substances and paste-like heat conducting substances such as thermal grease, thermal pastes, silicone grease, and heat sink compounds.

An advantageous effect according to an embodiment of the present invention will be described below.

As for the conventional electric power steering device, an electronic controlling unit which controls driving of an electric motor has a rectangular housing.

In contrast to this, as for the electric power steering device according to an embodiment of the present invention, in the housing 90 of the electronic controlling unit 50 that controls driving of the electric motor 12, the two opposite side wall portions 90a and 90b of the four side wall portions 90a to 90d are configured, as inclined side wall portions, to be inclined at an acute angle θ with respect to the mounting portion 90y, as illustrated in FIG. 9.

With the electronic controlling unit 50 according to an embodiment of the present invention, the volume of the electronic controlling unit 50 can be reduced without changing the thickness of the electronic controlling unit 50 and the footprint (projection area) of the electronic controlling unit 50 when viewed in a plan view. This makes it possible to make the electronic controlling unit 50 smaller than the conventional rectangular electronic controlling unit. This, in turn, makes it possible to provide an electronic controlling unit 50 which can have a relatively small size, an electric power steering device which uses the electronic controlling unit 50, and a vehicle equipped with the electric power steering device.

The volume of the electronic controlling unit 50 can be reduced without reducing the area of the mounting portion 90y, which can be stably attached to the electric motor 12 while achieving downsizing.

In the electronic controlling unit 50 according to an embodiment of the present invention, the first and second power modules 60A and 608 are tilted such that the sealing members 61 extend along the side wall portions (inclined side wall portions) 90a and 90b.

With the electronic controlling unit 50 according to an embodiment of the present invention, the degree of freedom of arrangement of other electronic components (discrete components) to be placed between the input/output board 70 and the control board 80 can be set higher than that when a power module is interposed between the input/output board 70 and the control board 80.

In the first and second power modules 60A and 60B of the electronic controlling unit 50 according to an embodiment of the present invention, the sealing members 61 are connected to the side wall portions (inclined side wall portions) 90a and 90b directly or indirectly via heat conducting members.

With the electronic controlling unit 50 according to an embodiment of the present invention, heat generated by the first and second power modules 60A and 60B can be efficiently transferred to the housing 90 so that the heat radiation performance of the electronic controlling unit 50 can be improved, compared to the conventional case where a power module is accommodated in the housing without contact. This makes it possible to provide an electronic controlling unit 50 which can have a relatively small size and a relatively high heat radiation performance, an electric power steering device which uses the electronic controlling unit 50, and a vehicle equipped with the electric power steering device.

Of the four side wall portions 90a, 90b, 90c, and 90d of the housing 90, the two side wall portions 90a and 90b connected to the first and second power modules 60A and 60B are inclined to the inner side of the housing 90. Hence, the area of heat radiation of a heat radiator including the two side wall portions 90a and 90b can be increased without changing the thickness of the electronic controlling unit 50 and the footprint (projection area) of the electronic controlling unit 50 when viewed in a plan view.

In the electronic controlling unit 50 according to an embodiment of the present invention, each of the plurality of first leads 63 of each of the first and second power modules 60A and 60B includes a first portion 63a, a second portion 63b, and a third portion 63c, as illustrated in FIG. 8. The first portion 63a projects from the sealing member 61. The second portion 63b is bent in the direction of thickness of the sealing member 61 from the first portion 63a. The third portion 63c is bent from the second portion 63b toward the back surface of the sealing member 61. The third portion 63c is bent nearly perpendicularly to the electronic component mounting surface of the input/output board 70, as illustrated in FIG. 9. In each of the first and second power modules 60A and 60B, a first portion 64a and a second portion 64b are provided as illustrated in FIG. 8. The first portion 64a projects from the sealing member 61. The second portion 64b is bent and tilted from the first portion 64a toward the back surface of the sealing member 61. The second portion 64b is bent nearly perpendicularly to the electronic component mounting surface of the control board 80, as illustrated in FIG. 9.

With the electronic controlling unit 50 according to an embodiment of the present invention, the first and second power modules 60A and 60B can be mounted on the input/output board 70 and the control board 80 to have a tilt with respect to the input/output board 70 and the control board 80 opposed to each other with a predetermined spacing between them in the Z-direction.

The third portions 63c of the first leads 63 are placed nearly perpendicular to the electronic component mounting surface of the input/output board 70. Thus, at the time of assembly of an electronic controlling unit 50, it is possible to easily insert the third portions 63c of the first leads 63 into the through-hole electrodes 70s of the input/output board 70 and the second portions 64b of the second leads 64 into the through-hole electrodes 80s of the control board 80, even when the first and second power modules 60A and 60B are tilted with respect to the input/output board 70 and the control board 80, as illustrated in FIG. 9.

The above-described embodiment assumes an electronic controlling unit 50 including a housing 90 having four side wall portions 90a, 90b, 90c, and 90d. However, the present invention is not limited to this and is applicable to an electronic controlling unit including a housing having more than four side wall portions.

The above-described embodiment further assumes an electronic controlling unit 50 including two, first and second power modules 60A and 60B. However, the present invention is not limited to this and is applicable to an electronic controlling unit including one or three or more power modules.

The above-described embodiment assumes that the two side wall portions 90a and 90b of the four side wall portions 90a, 90b, 90c, and 90d are inclined as inclined side wall portions . However, the present invention is not limited to this and at least one side wall portion may be inclined as inclined side wall portions. Note, however, that the side wall portions are preferably inclined as inclined side wall portions, depending on the number of power modules.

The present invention has specifically been described based on the above-described embodiment. However, the present invention is not limited to the above-described embodiment and various changes can be made without departing from the scope of the invention as defined by the claims, as a matter of course.

For example, windings of a plurality of systems may be applied to one electric motor to drive the winding of each system using an independent power module.

### Reference Signs List

1... steering wheel, 2... steering shaft, 2a... input shaft, 2b... output shaft, 3... steering torque sensor, 4... universal joint, 5... lower shaft, 6... universal joint, 7... pinion shaft, 8... steering gear, 8a... pinion, 8b... rack, 9... tie rod, 10... steering assist mechanism, 11... reduction gear, 12... electric motor, 12a... drive shaft, 13... motor rotational angle detection circuit, 20... motor controlling device, 21... vehicle speed sensor, 22... battery, 31... control computing device, 32A... first motor drive circuit, 32B... second motor drive circuit, 33A... motor current cutoff circuit, 33B... motor current cutoff circuit, 39A, 39B... current detection circuit, 41A, 41B... gate drive circuit, 42A, 42B... inverter circuit, 43... noise filter, 44A, 44B... power cutoff circuit, 50... electronic controlling unit (ECU), 60A... first power module, 60B... second power module, 61... sealing member, 61a, 61b... long side, 61c, 61d... short side, 62... notched portion, 63... first lead, 63a... first portion, 63b... second portion,
63c... third portion, 64... second lead, 64a... first portion, 64b... second portion, 65... screw member, 70... input/output board, 70a, 70b... side, 71... power input connector (input connector), 73... electronic component (discrete component), 73a, 73b... coil, 75... screw member, 80... control board, 80aa, 80bb... side, 82A, 82B... gate drive device, 90... housing (accommodation body), 90a, 90b, 90c, 90d... side wall portion, 90x... ceiling portion, 90y... mounting portion 91... case, 91a, 91b, 91c, 91d... side wall portion, 91x... ceiling portion, 92... cover, Q1 to Q6, QA1 to QA3, QB1 to QB3... field-effect transistor

## Claims

1. An electronic controlling unit (50) comprising:
a power module (60A, 60B) including a switching element;
an input/output board (70) including an input power connector (71) and an output connector for providing current to an electric motor (12);
a control board (80) including a controller configured to control an output current of the power module (60A, 60B); and
a housing (90) configured to accommodate the power module (60A, 60B), the input/output board (70), and the control board (80),
wherein the housing (90) includes a mounting portion (90y) and a ceiling portion (91x) opposed to each other with a spacing therebetween in one direction, and at least four side wall portions (91a-91d) located between the mounting portion (90y) and the ceiling portion (91x),
**characterized in that**
at least one of the at least four side wall portions (91a-91d) is an inclined side wall portion inclined inwardly at an acute angle with respect to the mounting portion (90y);
wherein
the input/output board (70) and the control board (80) are opposed to each other with a predetermined spacing therebetween in the one direction,
the power module (60A, 60B) includes a sealing member (61) having a square planar shape, a plurality of first leads aligned along one side of two opposite sides of the sealing member (61), and a plurality of second leads aligned along the other side of the two sides of the sealing member (61),
the first leads are connected to the input/output board (70),
the second leads are connected to the control board (80), and
the sealing member (61) is tilted along the inclined side wall portion.

2. The electronic controlling unit (50) according to claim 1, wherein the sealing member (61) is connected to the inclined side wall portion directly or indirectly via a heat conducting member.

3. The electronic controlling unit (50) according to claim 1 or 2, wherein the electronic controlling unit (50) is used to control driving of an electric motor (12).

4. An electric power steering device comprising the electronic controlling unit (50) according to claim 3, wherein the electric motor (12) generates a steering assist force to assist steering operation.

5. A vehicle comprising the electric power steering device according to claim 4.

## Patentansprüche

1. Elektronische Steuereinheit (50), umfassend:
ein Leistungsmodul (60A, 60B) mit einem Schaltelement;
eine Eingabe-/Ausgabe-Platine (70), die einen Eingangsleistungsverbinder (71) und einen Ausgangsverbinder zur Stromversorgung eines Elektromotors (12) enthält;
eine Steuerplatine (80) mit einer Steuerung, die zum Steuern eines Ausgangsstroms des Leistungsmoduls (60A, 60B) konfiguriert ist; und
ein Gehäuse (90), das zur Aufnahme des Leistungsmoduls (60A, 60B), der Eingabe-/Ausgabe-Platine (70) und der Steuerplatine (80) konfiguriert ist,
wobei das Gehäuse (90) einen Montageabschnitt (90y) und einen Deckenabschnitt (91x) aufweist, die einander mit einem Abstand dazwischen in einer Richtung gegenüberliegen, und mindestens vier Seitenwandabschnitte (91a - 91d), die zwischen dem Montageabschnitt (90y) und dem Deckenabschnitt (91x) angeordnet sind,
**dadurch gekennzeichnet, dass**
mindestens einer der mindestens vier Seitenwandabschnitte (91a - 91d) ein geneigter Seitenwandabschnitt ist, der in einem spitzen Winkel in Bezug auf den Montageabschnitt (90y) nach innen geneigt ist;
wobei
die Eingabe-/Ausgabe-Platine (70) und die Steuerplatine (80) sich mit einem vorbestimmten Abstand dazwischen in der einen Richtung gegenüber liegen,
das Leistungsmodul (60A, 60B) ein Dichtungselement (61) mit einer quadratischen planaren Form, einer Mehrzahl von ersten Leitungen, die entlang einer Seite von zwei gegenüberliegenden Seiten des Dichtungselements (61) ausgerichtet sind, und eine Mehrzahl von zweiten Leitungen umfasst, die entlang der anderen Seite der beiden Seiten des Dichtungselements (61) ausgerichtet sind,
die ersten Leitungen mit der Eingabe-/Ausgabe-Platine (70) verbunden sind,
die zweiten Leitungen mit der Steuerplatine (80) verbunden sind, und wobei
das Dichtungselement (61) entlang dem geneigten Seitenwandabschnitt geneigt ist.

2. Elektronische Steuereinheit (50) nach Anspruch 1, wobei das Dichtungselement (61) direkt oder indirekt über ein Wärmeleitungselement mit dem geneigten Seitenwandabschnitt verbunden ist.

3. Elektronische Steuereinheit (50) nach Anspruch 1 oder 2, wobei die elektronische Steuereinheit (50) verwendet wird, um den Antrieb eines Elektromotors (12) zu steuern.

4. Elektrische Servolenkungsvorrichtung mit der elektronischen Steuereinheit (50) nach Anspruch 3, wobei der Elektromotor (12) eine Lenkhilfskraft zum Unterstützen des Lenkvorgangs erzeugt.

5. Fahrzeug, umfassend die elektrische Servolenkungsvorrichtung nach Anspruch 4.

## Revendications

1. Unité de commande électronique (50) comprenant :
un module de puissance (60A, 60B) incluant un élément de commutation ;
une carte d'entrée/sortie (70) incluant un connecteur d'alimentation d'entrée (71) et un connecteur de sortie pour fournir un courant à un moteur électrique (12) ;
une carte de commande (80) incluant un contrôleur configuré de manière à commander un courant de sortie du module de puissance (60A, 60B) ; et
un boîtier (90) configuré de manière à recevoir le module de puissance (60A, 60B), la carte d'entrée/sortie (70) et la carte de commande (80) ;
dans lequel le boîtier (90) inclut une partie de montage (90y) et une partie de plafond (91x) opposées l'une à l'autre avec un espacement entre elles dans une direction, et au moins quatre parties de paroi latérale (91a-91d) situées entre la partie de montage (90y) et la partie de plafond (91x),
**caractérisé en ce que**
au moins l'une desdites au moins quatre parties de paroi latérale (91a-91d) est une partie de paroi latérale inclinée vers l'intérieur selon un angle aigu par rapport à la partie de montage (90y) ;
dans laquelle :
la carte d'entrée/sortie (70) et la carte de commande (80) sont opposées l'une à l'autre avec un espacement prédéterminé entre elles dans une direction ;
le module de puissance (60A, 60B) inclut un élément d'étanchéité (61) présentant une forme plane carrée, une pluralité de premiers fils alignés le long d'un côté de deux côtés opposés de l'élément d'étanchéité (61), et une pluralité de seconds fils alignés le long de l'autre côté des deux côtés de l'élément d'étanchéité (61) ;
les premiers fils sont connectés à la carte d'entrée/sortie (70) ;
les seconds fils sont connectés à la carte de commande (80) ; et
l'élément d'étanchéité (61) est penché le long de la partie de paroi latérale inclinée.

2. Unité de commande électronique (50) selon la revendication 1, dans lequel l'élément d'étanchéité (61) est connecté à la partie de paroi latérale inclinée, directement, ou indirectement par l'intermédiaire d'un élément thermoconducteur.

3. Unité de commande électronique (50) selon la revendication 1 ou 2, dans laquelle l'unité de commande électronique (50) est utilisée pour commander l'entraînement d'un moteur électrique (12).

4. Dispositif de direction assistée électrique comprenant l'unité de commande électronique (50) selon la revendication 3, dans lequel le moteur électrique (12) génère une force de direction assistée pour assister l'opération de direction.

5. Véhicule comprenant le dispositif de direction assistée électrique selon la revendication 4.
